# EUROPÄISCHE PATENTSCHRIFT

(11) **EP 3 134 771 B1**
(45) Veröffentlichungstag und Bekanntmachung des Hinweises auf die Patenterteilung: **28.08.2019**
(21) Anmeldenummer: 14719720.6
(22) Anmeldetag: 22.04.2014
(51) Int. Cl.: G03F 7/00

(54) **VERFAHREN UND VORRICHTUNG ZUM PRÄGEN EINER NANOSTRUKTUR**
METHOD AND DEVICE FOR EMBOSSING A NANOSTRUCTURE
PROCÉDÉ ET DISPOSITIF DE MARQUAGE D'UNE NANOSTRUCTURE

(43) Veröffentlichungstag der Anmeldung: 01.03.2017
(60) Teilanmeldung: 19186550.0
(73) Patentinhaber: Ev Group E. Thallner GmbH, 4782 St. Florian am Inn (AT)
(72) Erfinder: KREINDL, Gerald, A-4780 Schärding (AT)
(74) Vertreter: Schneider, Sascha
(86) Internationale Anmeldenummer: PCT/EP2014/058141
(87) Internationale Veröffentlichungsnummer: WO 2015/161868

(56) Entgegenhaltungen:
- WO-A1-2013/118546
- WO-A2-2006/117745
- US-A1- 2006 130 678
- US-A1- 2010 072 652
- US-A1- 2010 297 282

## Beschreibung

Die vorliegende Erfindung betrifft ein Verfahren gemäß Patentanspruch 1 sowie eine korrespondierende Vorrichtung gemäß Patentanspruch 8.

Nanoimprint Lithographie (NIL) ist ein Abformungsverfahren, bei dem Nanostrukturen von einem Stempel in aushärtbare Materialien, z.B. Lack, abgeformt werden. Dabei ist nicht nur eine Abformung einer großen Zahl von Nanostruktur-Systemen möglich, sondern auch die Herstellung hochpräziser Nanostrukturen auf großen Flächen durch ein Step-and-Repeat oder ein Rolle-Verfahren. Damit kann eine hochauflösende Oberflächenstrukturierung durchgeführt werden. Prinzipiell unterscheidet man zwischen thermischen NIL (hot-embossing NIL) und UV-basierten NIL Verfahren.

Auf Grund der Viskosität des Photoresist-Lacks werden durch Kapillarwirkung die Zwischenräume des Stempels vollständig damit ausgefüllt. Bei UV-NIL wird der Stempel bei Raumtemperatur in den fließfähigen Lack gedrückt, während bei thermischen NIL-Verfahren der thermoplastische Lack bei erhöhter Temperatur (oberhalb der Glasübergangstemperatur) in den Lack gepresst werden muss. Der Stempel wird erst nach dem Abkühlen wieder entfernt. Beim UV-NIL lässt sich mit geringeren Anpressdrücken arbeiten und der Prozess kann bei Raumtemperatur stattfinden. Der UV-Lack vernetzt bei der Belichtung mit UV-Strahlung zu einem stabilen Polymer (Aushärtung). Die Strukturierung kann also mit "weichen" Polymer-Stempeln sowie mit harten Stempeln durchgeführt werden. Die weiche UV-NIL (soft UV-NIL) mit Polymeren als Stempelmaterialien ist je nach Anwendung eine oft kostengünstige Alternative zur Strukturierung mit harten Stempeln. Soft UV-NIL (also mit Polymer-Stempeln) wird auch mit harten Polymer-Stempeln durchgeführt. Der Elastizitätsmodul von Quarz beträgt ca. 100 GPa. Im Vergleich sind Elastizitätsmodule von Polymeren (harte und weiche Polymere) um bis zu einige Größenordnungen kleiner, daher werden diese im Vergleich zu Quarz als "weich" bezeichnet (Soft-Lithographie).

Die wichtigsten Parameter bei den NIL-Verfahren sind die Temperatur (vor allem bei hot-embossing NIL), der Einpressdruck und die Adhäsion zwischen Lack und Stempel. Um eine hohe Adhäsion zwischen Lack und Stempel zu verringern, sollte die Stempeloberfläche eine möglichst niedrige Oberflächenenergie - in Zusammenspiel mit dem Lack bzw. Resist - aufweisen.

Je nach Anwendung kann der 3-D strukturierte Lack selbst als funktionale Einheit verwendet werden oder dient als Maske für nachfolgende Ätzschritte.

Gerade bei großen Flächen ist es schwierig den Druck gleichmäßig über die gesamte Kontaktfläche zu verteilen und Unregelmäßigkeiten auszugleichen. Daher kann es zu inhomogener Strukturierung kommen. Um die Strukturierung von größeren Flächen durchzuführen, wird mit einer Walze geprägt oder alternativ mit einem kleineren Stempel nach und nach durch Versetzen des Stempels die gesamte Oberfläche Strukturiert ("step-and-repeat" Verfahren).

Nanoimprint wird zum Herstellen von Mehrschichtstrukturen und (kostengünstigen) Nanostrukturen (z.B. integrierte Schaltkreise in Silizium-Technik) mit einer Auflösung unterhalb der Beugungsgrenze von Licht verwendet. Einen großflächigen Nanoprägeprozess durchzuführen am gesamten Wafer ermöglicht Kosten, Aufwand und Zeitaufwand niedriger zu halten.

Prägedefekte die bei NIL auftreten können sind z.B. Risse, ungleichmäßig gefüllte Stempelstrukturen (daher z.B. Lufteinschlüsse), und ungleichmäßige Lack-Schichtdicke. Die Adhäsion zwischen Lack und Stempel ist kritisch. Ansonsten kommt es zu Verzerrungen oder Rissen. Weiche und auch harte Stempel können sich während des NIL-Prozesses durch den angelegten Druck verformen. Weiterhin sind (Schmutz-)Partikel sehr kritisch. Partikel, die sich dann zwischen z.B. Lack und Stempel befinden, führen zu Defekten im gesamten Umkreis der Partikel.

Eine hochauflösende Strukturierung im unteren nm-Bereich (≤ 50 nm) ist einer der wichtigsten Vorteile von NIL. Das Replizieren von Strukturen im Sub 20 nm Bereich ist allerdings noch eine Herausforderung.

Oft müssen, insbesondere bei größeren Wafern, mehrere Prägeschritte nacheinander ausgeführt werden um die gewünschte Maßgenauigkeit zu erreichen. Das Problem mit solchen Ausführungsformen ist aber, eine exakte Ausrichtung der vielen Prägeschritte mit dem Stempel zueinander zu gewährleisten. Meistens werden Ausrichtungsmarken oder Passmarken eingesetzt, die auf dem Substrat und/oder auf dem Stempel angeordnet sind. Hochgenaues, justiertes Prägen von verschiedenen Lagen übereinander ist nicht oder nur mit großem Aufwand möglich.

In US 2006/130678 A1 wird ein Imprintverfahren beschrieben, indem die Imprintmaske oder das Substrat zuerst dauerhaft verformt, und dann durch Kraftanwendung wieder flachgedrückt wird.

In US 2011/0217479 A1 wird ein Imprintverfahren beschrieben, in dem der Stempel zunächst durch Anlegen eines Vakuums an der Rückseite des Stempels verformt wird, und dann durch Druck, nach erstem Kontakt mit dem Prägematerial wieder entformt wird. Während des gesamten Imprintprozesses bleibt der Stempel mit der Stempelhalterung verbunden.

Aufgabe der vorliegenden Erfindung ist es, ein Verfahren und eine Vorrichtung zum Prägen einer Nanostruktur anzugeben, mit welchen großflächige Substrate möglichst ohne sich wiederholende Prozessschritte mit möglichst kleinen Strukturen geprägt werden können.

Diese Aufgabe wird mit den Merkmalen der Patentansprüche 1 und 8 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen, sofern sie durch den Schutzumfang der Ansprüche abgedeckt sind. Bei angegebenen Wertebereichen sollen auch innerhalb der genannten Grenzen liegende Werte als Grenzwerte offenbart gelten und in beliebiger Kombination beanspruchbar sein. Soweit zur Vorrichtung offenbarte Merkmale auch als Verfahrensmerkmale aufgefasst werden können, sollen diese auch als verfahrensgemäß gelten und umgekehrt.

Grundgedanke der vorliegenden Erfindung ist es, durch Vorspannung eines Nanostrukturstempels zunächst nur eine Teilfläche einer Stempelfläche mit dem Nanostrukturstempel zu kontaktieren und anschließend, durch Loslassen des Nanostrukturstempels, ein selbsttätiges Kontaktieren der Kontaktfläche zu bewirken, wobei bevorzugt die gesamte Stempelfläche ohne Wiederholen der vorgenannten Schritte geprägt wird.

Die Erfindung betrifft insbesondere eine Anlage und eine Methode einen großflächigen UV-NIL Nanoprägeprozess mit einem harten Nanostrukturstempel durchzuführen.

Die Erfindung betrifft insbesondere eine Anlage und eine Methode einen großflächigen Nanoprägeprozess durchzuführen. Der großflächige Nanoimprint Prozess (bis zu 18" Substrate oder mehr) wird mit einem harten UV transparenten Nanostrukturstempel - typischerweise im Wafer-Format - durchgeführt. Dabei wird der strukturierte Nanostrukturstempel mit einem vollflächig vorbelackten Substrat kontaktiert. Die Belackung kann vom Prägeprozess getrennt in einem eigenen Modul durchgeführt werden. Der Imprint erfolgt insbesondere unter Vakuum oder bei Umgebungsdruck unter Inertgas-Atmosphäre. Die Prägefront kann wahlweise mit einem Aktuator im Zentrum oder Substratrand gestartet werden. Durch das Ausbreiten der Prägefront wird die strukturierte Stempeloberfläche im aushärtbaren Material, insbesondere Resist-Lack, auf dem Substrat eingedrückt und die Strukturen des Nanostrukturstempels werden repliziert. Der Prozess kann bevorzugt zum Prägen einer ersten Schicht oder einer zweiten Lage in Kombination mit exakter Justage (SmartView Alignment) eingesetzt werden.

Die Erfindung kann in Kombination mit den etablierten industriellen Belackungsverfahren angewendet werden wie z.B. Spin-Coating Verfahren. Die Belackung kann vom Prägeprozess getrennt in einem eigenen Modul durchgeführt werden. Somit ist das Belacken vom Substrat schnell, defektfrei, vollflächig, frei von Partikel und standardisiert, was auch Durchsatz-Vorteile bringt beim Präge-Schritt. Prägen im Vakuum oder bei Umgebungsdruck unter Inertgas ist möglich für verminderte Prägedefekte (z.B. Lufteinschlüsse, usw.) und leichteres Trennen zwischen Nanostrukturstempel und Substrat. Ein wesentlicher Vorteil dieser neuen Technologie ist, dass auch vollflächig belackte Substrate bei Umgebungsdruck defektfrei kontaktiert werden können.

Weitere Vorteile:
- keine Verzerrung,
- Replizieren von Strukturen im Sub 10 nm Bereich,
- Kombination mit Alignment für hochgenaues, justiertes Prägen von verschiedenen Lagen übereinander z.B. unter Zuhilfenahme des SVA (SmartView® Alignment)-Verfahrens,
- eine höhere Auflösung ist möglich.

Die Erfindung betrifft insbesondere eine Methode und Vorrichtung zur Übertragung einer Struktur, insbesondere eine Mikro- oder bevorzugter einer Nanostruktur, von einem UV-transparenten Nanostrukturstempel auf eine Flachseite eines (voll)flächigen belackten Substrats mit einem, das Substrat auf einer Substrataufnahmefläche aufnehmenden Substrathalter, einer parallel zur Substrataufnahmefläche ausrichtbaren und gegenüberliegend zu dieser anordenbaren Strukturfläche des Nanostrukturstempels und einem, orthogonal zur Substrataufnahmefläche und zur Strukturfläche des Nanostrukturstempels wirkenden Aktuator.

Die Erfindung basiert auf einem großflächigen Nanoimprint-Prozess mittels hartem UV-transparenten Stempel. Der Nanostrukturstempel kann auch für andere Bereiche der elektromagnetischen Strahlung transparent sein. Mit Wafer ist ein Substrat oder Produktsubstrat, beispielweise ein Halbleiterwafer gemeint. Auch Substrate mit Loch wie HDDs sind damit gemeint. Die Produktsubstrate können auch beidseitig strukturierte bzw. prozessierte Produktsubstrate sein. Das Substrat kann jede Form haben, mit Vorzug rund, rechteckig oder quadratisch, mit größerem Vorzug im Wafer Format. Der Durchmesser der Substrate beträgt mehr als 2 Zoll, mit Vorzug mehr als 4 Zoll, mit größerem Vorzug mehr als 6 Zoll, mit noch größerem Vorzug mehr als 8 Zoll, mit größtem Vorzug mehr als 12 Zoll, mit allergrößtem Vorzug mehr als 18 Zoll. Quadratische Glas-Substrate haben Abmessungen von 5 mm x 5 mm bis 20 mm x 20 mm oder größer. Rechteckige Glass-Substrate haben insbesondere Abmessungen von 5 mm x 7 mm bis 25 mm x 75 mm oder größer. Der Nanostrukturstempel kann jede Form haben, mit Vorzug rund, rechteckig oder quadratisch, mit größerem Vorzug Wafer-Format. Der Durchmesser der Nanostrukurstempel stimmt vorzugsweise weitgehend mit dem Durchmesser der Substrate überein.

Die Nanostrukturstempel sind mit Vorzug aus harten UV-transparenten Materialien wie Quarz/ Siliziumdioxid, mit größerem Vorzug sind es UV-transparente Polymer-Stempel wie u.a. Polydimethylsiloxan, Polytetrafluorethylen, perfluorierte Polyether, Polyvinylalkohol, Polyvinylchlorid, Ethylentetrafluorethylen gebildet, mit allergrößtem Vorzug sind es harte UV-transparente Polymere. Das erfindungsgemäße Stempelmaterial ist bei UV-Aushärtung des Prägematerials am Substrat mit Vorzug zumindest teilweise transparent für den Wellenlängenbereich der elektromagnetischen Strahlung, welche das Prägematerial vernetzt. Die optische Transparenz ist dabei insbesondere größer als 0%, mit Vorzug größer als 20%, mit größerem Vorzug größer als 50%, mit größtem Vorzug größer als 80%, mit allergrößtem Vorzug größer als 95%. Der Wellenlängenbereich für die optische Transparenz liegt insbesondere zwischen 100 nm und 1000 nm, vorzugsweise zwischen 150 nm und 500 nm, mit größerem Vorzug zwischen 200 nm und 450 nm, mit größtem Vorzug zwischen 250 nm und 450 nm.

Der UV-transparente und/oder IR-transparente Nanostrukturstempel kann jede Form haben, mit Vorzug rund, rechteckig oder quadratisch, mit größerem Vorzug Wafer-Format. Der Durchmesser der Nanostrukturstempel stimmt vorzugsweise mit dem Durchmesser der Substrate im Wesentlichen überein. Der Nanostrukturstempel kann eine, der zu behandelnden SubstratOberfläche zugewandten Seite befindliche, positive und/oder negative Profilierung aufweisen.

Besonders kritisch ist das Ablegen/Kontaktieren von Substrat und Nanostrukturstempel, da hier Fehler auftreten können, wobei sich die Fehler addieren können und somit eine reproduzierbare Justiergenauigkeit nicht eingehalten werden kann. Dies führt zu erheblichem Ausschuss. Bei dem kritischen Schritt der Kontaktierung der ausgerichteten Kontaktflächen von Substrat und Nanostrukturstempel ist eine immer exaktere Justiergenauigkeit beziehungsweise Offset von weniger als 100 µm gewünscht, insbesondere weniger als 10 µm, vorzugsweise weniger als 1 µm, mit aller größtem Vorzug kleiner als 100 nm, am bevorzugtesten weniger als 10 nm. Bei solchen Ausrichtungsgenauigkeiten sind viele Einflussfaktoren zu berücksichtigen. Die Vorrichtung dieser Erfindung ist als eine Weiterentwicklung der Vorrichtung, die erstmals in der Patentschrift AT405775B erwähnt wurde, zu sehen. In AT405775B werden ein Verfahren und eine Vorrichtung zum ausgerichteten Zusammenführen von scheibenförmigen Halbleitersubstraten beschrieben. Bei der neuen erfindungsgemäßen Vorrichtung werden Substrat und Nanostrukturstempel ausgerichtet zusammengeführt, sodass Annäherung und Justierung für einen nanoimprint Prägeprozess mit hartem Stempel kontrolliert durchgeführt werden. Die Anlage verfügt vorzugsweise über ein System für einen kontaktlosen Keilfehlerausgleich zwischen den parallel ausgerichteten Stempel und Substrat (siehe WO2012/028166A1).

Der Erfindung liegt insbesondere der Gedanke zugrunde, Substrat und Nanostrukturstempel möglichst koordiniert und gleichzeitig quasi-selbsttätig zu kontaktieren, indem zumindest der Nanostrukturstempel, mit einer, insbesondere konzentrisch zur Mitte M einer Kontaktfläche des Nanostrukturstempels radial nach außen verlaufenden, Vorspannung vor dem Kontaktieren beaufschlagt wird und dann nur der Beginn des Kontaktierens beeinflusst wird, während nach Kontaktierung eines Abschnitts, insbesondere der Mitte M des Stempels, der Nanostrukturstempel freigelassen wird und selbsttätig auf Grund seiner Vorspannung kontrolliert das gegenüberliegende Substrat prägt. Die Vorspannung wird durch eine Verformung des Nanostrukturstempels mittels Verformungsmitteln erreicht, wobei die Verformungsmittel insbesondere auf Grund ihrer Form auf die, zur Prägeseite abgewandten Seite einwirken und die Verformung entsprechend durch Einsatz unterschiedlicher, austauschbarer, Verformungsmittel steuerbar ist gemäß der Erfindungsmeldung WO2013/023708A1. Die Steuerung erfolgt durch den Druck oder die Kraft, mit der die Verformungsmittel auf den Nanostrukturstempel wirken.

Die Vorrichtung kann vorteilhaft auch im Vakuum oder auch bei Umgebungsdruck unter Inertgas betrieben werden, wodurch mit Vorteil Prägedefekte wie z.B. Lufteinschlüsse vermieden werden. Wird die Vorrichtung im Vakuum betrieben, ist der Druck kleiner als 500 mbar, mit Vorzug kleiner als 100 mbar, mit größtem Vorzug kleiner als 10 mbar, mit allergrößtem Vorzug kleiner als 1 mbar.

Eine bevorzugt vorhandene Gasatmosphäre kann den Kontaktier-Vorgang dämpfen und somit verhindern, dass die Kontaktflächen vorzeitig bzw. an mehreren Stellen gleichzeitig in Kontakt kommen, was zu Verzerrungen führen würde. Andererseits kann es zu Gaseinschlüssen kommen. Daher ist es notwendig und sinnvoll, den Prozess zu optimieren und insbesondere den Umgebungsdruck während dem Kontaktieren an die Gegebenheiten der Substrate und Nanostrukturstempel anzupassen.

Eine sehr häufig verwendete Art der Fixierung von Substrat und Nanostrukturstempel am jeweiligen Probenhalter erfolgt mit Hilfe von Vakuum bzw. Unterdruck. Substrat und Nanostrukturstempel werden auf einer planen gehärteten Oberfläche, in welche Vakuumbahnen gefräst sind, durch Unterdruck bzw. Vakuum fixiert. Der Probenhalter (Substrataufnahmeeinrichtung) für das Substrat hat Vakuumbahnen auf der gesamten Fläche oder auf Außenzonen der Fläche. Mit Vorteil verläuft der Unterdruckkanal konzentrisch, insbesondere kreisförmig, zu einem Zentrum Z der Aufnahmeeinrichtung, insbesondere vollumfänglich. Hierdurch wird eine gleichmäßige Fixierung erreicht. Weiterhin kann bei Bedarf die Kontur der Aufnahmefläche gegenüber der Aufnahmeebene der Aufnahmefläche zurückgesetzt sein, sodass Vertiefungen gebildet werden, die die Auflagefläche verkleinern bzw. verändern. Somit können auch beidseitig strukturierte bzw. prozessierte Substrate (Produktsubstrate) eingesetzt werden.

Der Probenhalter für den Nanostrukturstempel hat insbesondere eine Bohrung für den Aktuator und Vakuumbahnen im Randbereich. Hier ist mindestens ein die Aufnahmefläche unterbrechender Unterdruckkanal in dem äußeren Ringabschnitt der Aufnahmekontur vorgesehen. Je nach Bedarf kann die Aufnahmefläche der Aufnahmeeinrichtung reduziert werden, sodass sich eine kleinere Kontaktfläche zwischen Substrat und Probenhalter ergibt.

Weitere Möglichkeiten der Fixierung von Substrat und Nanostrukturstempel am jeweiligen Probenhalter sind die mechanische Fixierung durch Klemmen oder eine elektrostatischen Fixierung. Auch Probenhalter mit Pins (engl. pin chuck) werden eingesetzt. Spezialklebstoffe können auch eingesetzt werden.

Eine erfindungsgemäße Ausführungsform der Substrataufnahmeeinrichtung ermöglicht außerdem das Handling von Substraten insbesondere Wafern, mit flüssiger Schicht drauf. Die flüssige Schicht ist insbesondere ein flüssiger Prägelack der sich im Interface während des Kontaktierens befindet.

Die Belackung kann insbesondere vom Prägeprozess getrennt in einem eigenen Modul durchgeführt werden. Somit können standardisierte Belackungs-Verfahren eingesetzt werden unter kontrollierten Bedingungen, was Durchsatz-Vorteile beim darauffolgenden Prägeschritt bringt. Das Substrat wird vollflächig mit einem Nanoimprint-Lack in einer Belackungskammer vorbelackt. Die Aufbringung der Schichten erfolgt insbesondere mit Spin-, Sprüh- oder Inkjet-Verfahren sowie Tauchbeschichtungs- oder Walzenbeschichtungsverfahren. Wahlweise wird anschließend das Lösungsmittel verdampft und der Wafer in eine Prägekammer transferiert.

Materialien für die zu prägende Substratoberfläche bzw. Substrat-Beschichtung können insbesondere UV-härtbare Stoffe oder thermisch härtbare Stoffe wie Polymere oder Lacke sein. Bei der UV-Nanoimprint Lithographie wird der Nanostrukturstempel bei Raumtemperatur in den fließfähigen Lack gedrückt, während bei thermischen Verfahren der thermoplastische Lack bei erhöhter Temperatur in den Lack gepresst wird. Die Aushärtung erfolgt je nach Lack-Material bevorzugt durch UV-Licht aber auch möglicherweise durch IR-Licht. Allgemeiner kann die Aushärtung durch elektromagnetische Strahlung, durch Wärme, durch Strom, durch magnetische Felder oder andere Verfahren durchgeführt werden. Der Aushärtung liegt erfindungsgemäß bevorzugt eine Polymerisation des Grundmaterials zu Grunde. Dabei wird die Polymerisation durch einen sogenannten Initiator gestartet.

Eine zusätzliche Antihaftbeschichtung bzw. die Aufbringung eines Haftvermittlers oder die Aufbringung eines Trennmittels am Nanostrukturstempel sind gemäß einer vorteilhaften Ausführungsform vorgesehen. Der Nanostrukturstempel wird mit einer Antihaftschicht beschichtet, um zusätzlich eine Verringerung der Adhäsion zwischen erfindungsgemäßen Nanostrukturstempel und Substrat-Beschichtung (Prägemasse) zu erreichen. Mit Vorzug handelt es sich bei der Antihaftschicht um organische Moleküle mit entsprechend niedrigen Adhäsionseigenschaften zur Substrat-Beschichtung. Die Schichtdicke der Beschichtung ist insbesondere kleiner als 1 mm, mit Vorzug kleiner als 100 µm, mit größerem Vorzug kleiner als 10 µm, mit größtem Vorzug kleiner als 1 µm, mit allergrößtem Vorzug kleiner als 100 nm, am bevorzugtesten kleiner als 10 nm. Eine geringe Schichtdicke hat einen positiven Effekt auf die Durchlässigkeit der verwendeten elektromagnetischen Strahlung die z.B. zur UV-Aushärtung verwendet wird. Als Trennmittel werden z.B. selbstorganisierte Monoschichten (SAM) oder Multischichten verwendet. Eine Oberflächenaktivierung mittels Plasma wäre Denkbar als weiter Vorbehandlungsschritt.

Durch Integration eines Lampenhauses in einer erfindungsgemäßen Ausführungsform der Vorrichtung wird mit UV-Licht, insbesondere durch den Nanostrukturstempel hindurch, belichtet, um das Aushärten des Prägelacks mit UV-Licht zu ermöglichen. Der Nanostrukturstempel, sowie gegebenenfalls auch andere angrenzenden Bestandteile der Stempelhalterung sind aus UV- und/oder IR-transparenten Materialien gefertigt.

Das Substrat und der Nanostrukturstempel werden während des Evakuierungs- und/oder Inertgas Spülvorgangs in Separation gehalten, wobei der transparente Nanostrukturstempel oben (Strukturierte Seite nach unten) und das Substrat unten gehalten wird. Die Steuerung der Verformung des Nanostrukturstempels erfolgt durch den Druck oder die Kraft, mit der die Verformungsmittel auf dem Nanostrukturstempel wirken. Vorteilhaft ist es dabei, die wirksame Aufnahmefläche der Aufnahmeeinrichtung mit dem Nanostrukturstempel zu reduzieren, so dass der Nanostrukturstempel nur teilweise von der Aufnahmeeinrichtung gestützt wird, bevorzugt nur am Rand gestützt wird. Auf diese Weise ergibt sich durch die kleinere Kontaktfläche am Rand eine geringere Adhäsion zwischen dem Nanostrukturstempel und dem Stempelhalter bzw. der Stempelaufnahmeeinrichtung. Das ermöglicht ein schonendes und sicheres Ablösen des Nanostrukturstempels, mit Lösekräften die so gering wie möglich sind. Das Ablösen des Nanostrukturstempels ist somit kontrollierbar, insbesondere durch Reduzierung des Unterdrucks an der Aufnahmefläche.

Der Nanoimprintprozess wird vorzugsweise mit einem Aktuator (Pin) wahlweise im Substratzentrum M oder Substratrand R initiiert. Dabei wird der UV-transparente Nanostrukturstempel mit dem Aktuator lokal durchgebogen (Verformung), um den ersten Kontaktpunkt (Teilfläche der Stempelfläche) mit dem flüssigen Prägelack auf dem Substrat zu definieren. Nachdem der erste Kontaktpunkt erreicht wurde, wird der Druck an Vakuumbahnen der Stempelaufnahmeeinrichtung unterbrochen oder, insbesondere getrennt für jede Vakuumbahn, reduziert, sodass der Stempel abgelöst wird und die Prägefront selbständig über die gesamte Stempelfläche verlaufen kann. Die Vakuumbahnen des oberen Probenhalters sind bevorzugt im Randbereich angeordnet, sodass das Ablösen vom Nanostrukturstempel kontrolliert, insbesondere durch Reduzierung des Unterdrucks an der Aufnahmefläche durchgeführt wird. Erst durch gesteuerte Reduzierung des Unterdrucks wird ein Loslösen des Nanostrukturstempels von der Stempelaufnahmeeinrichtung, insbesondere vom Randbereich her, bewirkt.

Zuerst wird der transparente Nanostrukturstempel insbesondere am Top-Side Probenhalter (Stempelaufnahmeeinrichtung) geladen und mit einem Alignment-System erfasst. Danach wird das belackte Substrat geladen und beide Wafer mit einem Alignment-System hochgenau justiert für eine exakte Ausrichtung. Die Patentschrift DE 102004007060 B3 beschreibt eine Vorrichtung und Verfahren zum Verbinden von zwei Wafern, bzw. jede Art eines zu justierenden flächigen Bauteils, entlang ihrer korrespondierenden Oberflächen. Dabei werden die Wafer exakt ausgerichtet. Die Vorrichtung zum Nanoimprint-Prägen weist ähnliche Merkmale auf, wobei hier jeweils ein Substrat und ein Nanostrukturstempel exakt ausgerichtet werden: a) eine erste Einrichtung zur Aufnahme und Ausrichtung eines Nanostrukturstempels (Stempelaufnahmeeinrichtung), b) eine zweite Einrichtung zur Aufnahme und Ausrichtung eines Substrates gegenüber dem Nanostrukturstempel (Substrataufnahmeeinrichtung).

Das Kontaktieren der Kontaktflächen und Prägen der korrespondierenden Oberflächen mittels der Einrichtungen erfolgt an einer Prägeinitiierungsstelle. Das Nanoimprint-Prägen des Substrats mit dem Nanostrukturstempel erfolgt entlang einer von der Prägeinitiierungsstelle zu Seitenrändern des Nanostrukturstempels verlaufenden Prägefront durch Loslösen des Nanostrukturstempels von der Stempel-Aufnahmefläche.

Eine Erfassungseinrichtung (nicht dargestellt) sorgt gemäß einer vorteilhaften Ausführungsform für die exakte Ausrichtung von Substrat und Nanostrukturstempel, indem sie die relative Positionen erfasst, an die Steuerungseinheit weitergibt, welche dann eine Ausrichtung von Substrat und Nanostrukturstempel zueinander bewirkt. Die Ausrichtung erfolgt manuell oder automatisch (bevorzugt) mit einer Ungenauigkeit (engl. misalignment) von weniger als 100 µm, vorzugsweise weniger als 10 µm, noch bevorzugter weniger als 1 µm, mit aller größtem Vorzug weniger als 100 nm, am bevorzugtesten weniger als 10 nm.

Der Abstand zwischen Substrat und Nanostrukturstempel wird dann auf einen genau definierten Abstand reduziert, bevor der Nanoimprintprozess gestartet wird. Bei dem erfindungsgemäßen Prägeverfahren werden Substrat und Stempel nicht plan aufeinandergelegt, sondern zuerst in einem Punkt z.B. der Mitte M des Substrats miteinander in Kontakt gebracht, indem der Nanostrukturstempel durch Verformungsmittel leicht gegen das Substrat gedrückt und dabei verformt wird. Nach dem Loslösen des verformten i.e. durchgebogenen Nanostrukturstempels (in Richtung des gegenüberliegenden Substrats) erfolgt durch das Voranschreiten einer Prägewelle ein kontinuierliches und gleichmäßiges Prägen entlang der Prägefront.

Soweit als Verformungsmittel mindestens ein, die Aufnahmekontur durchsetzendes Druckelement (Aktuator) vorgesehen ist, kann der Druck gleichmäßig, insbesondere vom Zentrum Z aus, aufgebracht werden. Eine mechanische Lösung, insbesondere durch einen Stift oder Aktuator, ist bevorzugt vorgesehen. Weitere Verformungsmittel wie Beaufschlagung mit einem Fluid oder einem Gas sind erfindungsgemäß denkbar.

In einer ersten erfindungsgemäßen Ausführungsform wird der Nanoimprintprozess mit einem Aktuator im Substratzentrum (Mitte M) initiiert und die Prägefront breitet sich vom Zentrum, von innen nach außen, zum Wafer-Rand hin aus. Dabei ist es vorteilhaft, die resultierende Kraft Fₐ durch die Ansteuerung des Aktuators (Pin) bzw. der Aktuator-Einrichtung im Flächenschwerpunkt des Nanostrukturstempels und somit im Flächenschwerpunkt einer Kontaktfläche zwischen Substrat und Nanostrukturstempel wirken zu lassen. Dabei ist die Kraft Fₐ kleiner als 100 kN, mit Vorzug kleiner als 10 kN, mit größerem Vorzug kleiner als 1 kN, mit größtem Vorzug kleiner als 500 N, am bevorzugtesten kleiner als 100 N, mit allergrößtem Vorzug kleiner als 10 N.

In einer zweiten erfindungsgemäßen Ausführungsform wird der Nanoimprintprozess mit einem Aktuator am Substratrand initiiert und die Prägefront breitet sich vom Rand-Kontaktpunkt R weg. In dieser Ausführungsform wirkt die resultierende Kraft Fₐ durch die Ansteuerung des Aktuators bzw. der Aktuator-Einrichtung im Flächenrandbereich des Nanostrukturstempels. Durch Beaufschlagung des Nanostrukturstempels am Rand der Aufnahmefläche (an der Rückseite des Nanostrukturstempels) ist auch ein besonders schonendes Ablösen möglich.

In beiden Ausführungsformen läuft die Prägefront zumindest überwiegend selbständig über die gesamte Stempelfläche, insbesondere ausschließlich durch Gewichtskraft des Nanostrukturstempels bewirkt.

Anschließend wird in einer bevorzugten Ausführungsform der Waferstapel auf eine Unload-Station transferiert und der Lack durch den transparenten Stempel mittels UV-Licht vernetzt. Der Prägelack (aushärtbares Material) wird durch die UV-Vernetzung ausgehärtet. Das verwendete UV-Licht ist wahlweise breitbandiges Licht oder speziell abgestimmt auf den verwendeten Photoinitiator im Prägelack. Der Wellenlängenbereich des aushärtbaren Materials liegt insbesondere zwischen 50 nm und 1000 nm, vorzugsweise zwischen 150 nm und 500 nm, mit größerem Vorzug zwischen 200 nm und 450 nm.

Am Ende des Verfahrens wird der Nanostrukturstempel in der Prägekammer insbesondere vom Substrat abgezogen und das Substrat entladen.

In einer erfindungsgemäßen Anlage werden insbesondere die Prozess-Schritte Beschichtung von Substrat, Justierung, Prägen (Nanoimprint Lithographie), Entformen von Stempel und Substrat, und optional eine Inspektion (Metrologie) integriert. Denkbar wäre, die Entformung direkt in der Imprint-Stage durchzuführen, so verbleibt der Stempel in der Anlage im Unterschied zu Anlagen zum Wafer-Bonden gemäß z.B. AT405775B. Die Anlage verfügt vorzugsweise über Sensoren zur Kraftüberwachung für eine Kontrolle des Entformungsschrittes. Weiterhin sind insbesondere Vorkehrungen getroffen, um statische Aufladungen zu vermeiden. Das erfindungsgemäße Verfahren zum Nanoimprint Prägen von Substraten mit einem harten Polymerstempel weist also in einer allgemeinen Ausführungsform insbesondere folgende Schritte auf:
a) Substrat-Beschichtung bzw. Belackung, also Aufbringung des Strukturmaterials (Lack) auf das Substrat mittels einer Aufbringeinrichtung z.B. einer Spinbelackungsanlage,
b) Justierung von Substrat (Aufnahmeeinrichtung) und Nanostrukturstempel (Prägeeinrichtung) mittels einer Justiereinrichtung,
c) Prägen des Substrats durch die Prägeeinrichtung mit Aktuator,
d) UV-Belichtung des aushärtbaren Materials und Entformen von Nanostrukturstempel und Substrat.

Die Anlage verfügt insbesondere über eine Modulgruppe mit einem gemeinsamen, und bei Bedarf gegenüber der Umgebungsatmosphäre abschließbaren Arbeitsraum. Dabei können die Module, z.B. Belackungs-Modul (für z.B. Spin-Coating), Imprint-Modul und Entlade-Modul, clusterförmig oder sternförmig um ein Zentralmodul mit einer Bewegungseinrichtung (Robotersystem) angeordnet werden. Die Entformung kann direkt in der Imprint-Stage stattfinden. Ebenfalls kann die Belackung vom Prägeprozeß getrennt in einem eigenen Modul durchgeführt werden, was erhebliche Durchsatzvorteile bringt. Für verminderte Prägedefekte und leichteres Trennen zwischen Stempel und Substrat kann das Prägen auf der Imprint-Stage im Imprint-Modul im Vakuum und/oder unter Inertgas durchgeführt werden. Das Prägen unter Inertgasatmosphäre kann Vorteile bringen wie bessere chemische Beständigkeit, bessere Adhäsion und schnellere UV-Härtung. Alternativ kann der gesamte Arbeitsraum mit einem Inertgas beaufschlagt werden und/oder über eine Vakuumeinrichtung mit einem Vakuum als definierte Atmosphäre beaufschlagt werden. Auch der Aufbringvorgang (Beschichtung vom Substrat) kann in der oben beschriebenen definierten Atmosphäre durchgeführt werden. Somit können entstehende Gaseinschlüsse weitgehend vermieden oder ausgeschlossen werden.

Ein wesentlicher Vorteil dieser neuen Technologie ist, dass vollflächig belackte Substrate bei Umgebungsdruck und unter Inertgasatmosphäre defektfrei kontaktiert werden können.

Die erfindungsgemäße Ausführungsform der Anlage ermöglicht, insbesondere unter Zuhilfenahme einer Alignment Methode zum Ausrichten von zwei Elementen, also Substrat und Nanostrukturstempel ein justiertes Prägen von hochauflösenden Strukturen auf Wafer Ebene mit einer Sub 200 nm Justiergenauigkeit.

Die erfindungsgemäße Ausführungsform ermöglicht insbesondere ein verzerrungsfreies und großflächiges Prägen von hochauflösenden Strukturen. Ein Vorteil der erfindungsgemäßen Methode ist, dass vollflächig belackte Substrate bei Umgebungsdruck unter Inertgas defektfrei kontaktiert werden können. Weiterhin ist eine Automatisierung der Technologie möglich, sodass Belacken und Prägen schnell, gleichmäßig, defektfrei, frei von Fremdpartikel durchgeführt werden.

Artikel, die mit diesem Verfahren hergestellt werden können sind u.a. Hard Disk Drives (HDDs) der nächsten Generation wie Bit Patterned Media (BPM), Polarizer, Quantum-Dots, photonische Strukturen, optische Strukturen, sowie Strukturen für die Sequenzierung (Nanoporen, Nanodots, usw.). Die Ausführung der beschriebenen Methode für Substrate mit Loch (Harddisk) soll im speziellen erwähnt werden.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a:: eine Aufsicht auf eine Stempelaufnahmeeinrichtung einer bevorzugten Ausführungsform einer erfindungsgemäßen Vorrichtung mit einer Schnittlinie A-A,
- Figur 1b:: eine Querschnittsansicht gemäß Schnittlinie A-A aus Figur 1a,
- Figur 1c:: eine Querschnittsansicht einer zweiten Ausführungsform der Erfindung,
- Figur 2a:: eine Aufsicht auf eine Substrataufnahmeeinrichtung einer bevorzugten Ausführungsform der erfindungsgemäßen Vorrichtung mit einer Schnittlinie B-B,
- Figur 2b:: eine Querschnittsansicht gemäß Schnittlinie B-B aus Figur 2a,
- Figur 2c:: eine Querschnittsansicht einer zweiten Ausführungsform der Erfindung, insbesondere für beidseitig strukturierte Produktsubstrate,
- Figur 3a:: eine Aufsicht auf eine Substrataufnahmeeinrichtung einer zweiten Ausführungsform der erfindungsgemäßen Vorrichtung mit einer Schnittlinie C-C,
- Figur 3b:: eine Querschnittsansicht gemäß Schnittlinie C-C aus Figur 3a,
- Figur 3c:: eine Aufsicht auf ein Substrat mit Loch, insbesondere für die Herstellung einer Festplatte bzw. Harddisk,
- Figur 4a:: eine Aufsicht auf eine Substrataufnahmeeinrichtung einer dritten Ausführungsform der erfindungsgemäßen Vorrichtung mit einer Schnittlinie D-D,
- Figur 4b:: eine Querschnittsansicht gemäß Schnittlinie D-D aus Figur 4a,
- Figur 5a:: eine Querschnittsansicht der erfindungsgemäßen Vorrichtung in einem ersten erfindungsgemäßen Verfahrensschritt,
- Figur 5b:: eine Querschnittsansicht der erfindungsgemäßen Vorrichtung in einem zweiten erfindungsgemäßen Verfahrensschritt,
- Figur 5c:: eine Querschnittsansicht der erfindungsgemäßen Vorrichtung in einem dritten erfindungsgemäßen Verfahrensschritt,
- Figur 6a:: eine Querschnittsansicht der erfindungsgemäßen Vorrichtung in einem vierten erfindungsgemäßen Verfahrensschritt,
- Figur 6b:: eine Querschnittsansicht der erfindungsgemäßen Vorrichtung in einem fünften erfindungsgemäßen Verfahrensschritt nach Annäherung der Stempel- und Substrathalter,
- Figur 6c:: eine Querschnittsansicht der erfindungsgemäßen Vorrichtung in einem sechsten erfindungsgemäßen Verfahrensschritt, insbesondere während der Kontaktierung eines Nanostrukturstempels durch einen Aktuator zur elastischen Durchbiegung des Nanostrukturstempels und Kontaktierung des Nanostrukturstempels mit dem Substrat,
- Figur 6d:: eine Querschnittsansicht der erfindungsgemäßen Vorrichtung in einem siebten erfindungsgemäßen Verfahrensschritt während einer fortlaufenden Prägewelle entlang einer Prägefront zwischen Stempel und Substrat, wobei der Nanostrukturstempel von einer Stempelaufnahmeeinrichtung durch Unterbrechung von Vakuum in Vakuumbahnen abgelöst wird,
- Figur 6e:: eine Querschnittsansicht der erfindungsgemäßen Vorrichtung in einem achten erfindungsgemäßen Verfahrensschritt mit beendeter Prägefront,
- Figur 7a:: eine Querschnittsansicht der erfindungsgemäßen Vorrichtung in einer zweiten Ausführungsform des erfindungsgemäßen Verfahrens mit zentral auf dem Stempel positionierten Aktuator,
- Figur 7b:: eine Querschnittsansicht der erfindungsgemäßen Vorrichtung in der zweiten Ausführungsform des Verfahrens nach Annäherung der Stempel- und Substrathalter,
- Figur 7c:: eine Querschnittsansicht der erfindungsgemäßen Vorrichtung in der zweiten Ausführungsform des Verfahrens während der Kontaktierung des Stempels durch einen Aktuator, wobei durch den Aktuator eine elastische Durchbiegung des Nanostrukturstempels und eine Kontaktierung zwischen dem Nanostrukturstempel und dem Substrat mit Loch erfolgt,
- Figur 7d:: eine Querschnittsansicht der erfindungsgemäßen Vorrichtung in der zweiten Ausführungsform des Verfahrens während der fortlaufenden Prägewelle zwischen dem Nanostrukturstempel und dem Substrat mit Loch, wobei der Nanostrukturstempel von der Stempelaufnahmeeinrichtung durch Unterbrechung von Vakuum in Vakuumbahnen abgelöst wird,
- Figur 7e:: eine Querschnittsansicht der erfindungsgemäßen Vorrichtung in der zweiten Ausführungsform des Verfahrens mit beendeter Prägefront,
- Figur 8:: eine Querschnittsansicht der Substrataufnahmeeinrichtung nach dem Prägen, wobei der Waferstapel (Substrat mit aufliegendem Nanostrukturstempel) insbesondere auf eine Entlade-Station transferiert und das aushärtbare Material, insbesondere durch den transparenten Nanostrukturstempel hindurch, mittels UV-Licht vernetzt/ausgehärtet wird,
- Figur 9a:: eine Querschnittsansicht einer Ausführungsform des erfindungsgemäßen Verfahrens, wobei das Substrat und der Nanostrukturstempel von einem zentral auf den Nanostrukturstempel einwirkenden Aktuator beaufschlagt werden und
- Figur 9b:: einer Ausführungsform des erfindungsgemäßen Verfahrens, wobei das Substrat und der Nanostrukturstempel von einem am Rand des Substrats auf den Nanostrukturstempel einwirkenden Aktuator beaufschlagt werden.

In den Figuren sind gleiche Bauteile und Bauteile mit der gleichen Funktion mit den gleichen Bezugszeichen gekennzeichnet.

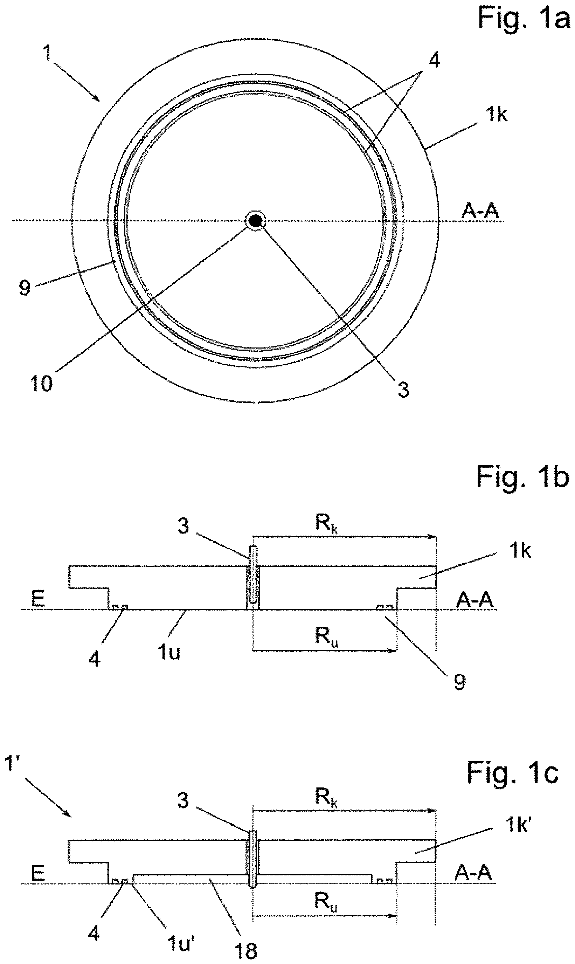

Figur 1a zeigt eine Stempelaufnahmeeinrichtung 1 einer Vorrichtung zur Aufnahme eines erfindungsgemäß zum Prägen einer Nanostruktur 13 vorgesehenen Nanostrukturstempels 5 auf einem Aufnahmekörper 1k. Der Aufnahmekörper 1k weist eine Struktur auf, die in einer Aufnahmeebene E eine Aufnahmefläche 1u aufweist, was in der Querschnittsansicht gemäß Figur 1b gut zu erkennen ist. Bei Aufnahme des Nanostrukturstempels 5 auf die Stempelaufnahmeeinrichtung 1 tritt nur die Aufnahmefläche 1u in Kontakt mit einer Aufnahmeseite 5a des Nanostrukturstempels 5. Gegenüberliegend zur Aufnahmeseite 5a ist eine Prägeseite 6 des Nanostrukturstempels 5 angeordnet.

Die Aufnahmefläche 1u der Aufnahmeeinrichtung 1 ist insbesondere an die Abmessungen und Umfangskontur des Nanostrukturstempels 5 angepasst. Der, insbesondere UV-transparente, Nanostrukturstempel 5 kann jede Form haben, insbesondere rund, rechteckig oder quadratisch, mit Vorzug ein Standard-Wafer-Format.

Der Durchmesser des Nanostrukturstempels 5 stimmt vorzugsweise weitgehend mit dem Durchmesser eines zu prägenden Substrats 7 überein oder ist größer als der Durchmesser der Substrate gewählt. Mit Vorzug ist der Durchmesser des Nanostrukturstempels 5 mindestens gleich groß wie der Durchmesser des Substrats 7, bevorzugter ist der Durchmesser des Nanostrukturstempels 5 um mehr als 5 mm größer, noch bevorzugter ist der Durchmesser des Nanostrukturstempels 5 um mehr als 10 mm größer als der Durchmesser des Substrats 7. Letzteres ist erfindungsgemäß bevorzugt der Fall, wenn die Stempelaufnahmeeinrichtung 1 (Nanostrukturstempel-Halterung) mit Vakuumbahnen 4 außerhalb einer aktiven Prägefläche der Prägeseite 6 versehen ist, um eine homogene Prägung am Substrat 7 zu erzielen. Bevorzugt überragt der Nanostrukturstempel 5 das Substrat 7 um maximal 50 mm.

Die Aufnahmefläche 1u ist in der Ausführungsform gemäß Figuren 1a und 1b kreisförmig und ein Radius Rᵤ der Aufnahmefläche 1u entspricht annähernd dem Radius der zu prägenden Substrate 7. Die Größe der Aufnahmefläche 1u für den Nanostrukturstempel 5 und einer Aufnahmefläche 2u für das Substrat 7 ist bevorzugt annähernd gleich groß oder leicht größer gewählt wie die Durchmesser des Substrats 7 und/oder des Nanostrukturstempels 5. Die Durchmesser der Substrate 7 entsprechen mit Vorzug den in der Halbleiterindustrie üblichen Durchmessern von 2", 4", 6", 8", 12" oder 18".

Ein Radius Rₖ des Aufnahmekörpers 1k kann, wie in der Ausführungsform gemäß Figur 1b gezeigt, größer sein als der Radius Rᵤ der Aufnahmefläche 1u, insbesondere durch einen gegenüber der Aufnahmefläche 1u zurückgesetzte ringförmigen Schulterabschnitt.

Bevorzugt ist nur ein äußerer Ringabschnitt 9 der Aufnahmefläche 1u zur Fixierung des Nanostrukturstempels 5 mittels der Vakuumbahnen 4 vorgesehen. Das erfindungsgemäße Verfahren wird dadurch verbessert, dass die Fixierung des Nanostrukturstempels 5 nur im Bereich eines Seitenrandes der Aufnahmefläche 1u stattfindet. Durch Reduzierung des Unterdrucks an der Aufnahmefläche 1u kann das Ablösen vom Nanostrukturstempel 5 kontrolliert, insbesondere vom Ringabschnitt 9 her, durchgeführt werden. Der Ringabschnitt 9 der Aufnahmefläche 1u erstreckt sich von der Außenkontur der Aufnahmefläche 1u zum Zentrum der Aufnahmefläche 1u, insbesondere in einer Breite von 0,1 mm bis 50 mm, bevorzugt in einer Breite von 0,1 mm bis 25 mm. Der Ringabschnitt 9 erstreckt sich insbesondere in einer Breite von 1/100 bis 1/5 vom Stempeldurchmesser, bevorzugt in einer Breite von 1/50 bis 1/10 vom Stempeldurchmesser. Im Ausführungsbeispiel gemäß Figur 1a wird der Unterdruck an zwei, insbesondere zueinander konzentrisch verlaufenden, Unterdruckkanälen bzw. Vakuumbahnen 4 durch eine Vakuumeinrichtung (nicht dargestellt) angelegt.

In Figur 1b ist die Aufnahmefläche 1u gemäß der ersten Ausführungsform der Stempelaufnahmeeinrichtung 1 vollflächig bzw. eben (abgesehen von den Vakuumbahnen 4) ausgebildet.

Gemäß einer weiteren Ausführungsform (Figur 1c) ist ein Aufnahmekörper 1k' einer zweiten Ausführungsform der Stempelaufnahmeeinrichtung 1' gegenüber der Aufnahmeebene E, insbesondere innerhalb einer Aufnahmefläche 1u', zurückgesetzt, sodass mindestens eine Vertiefung 18 gebildet wird. Hierdurch wird die Auflagefläche des Nanostrukturstempels 5, also die Aufnahmefläche 1u' gegenüber der Ausführungsform gemäß Figur 1a verkleinert. Die Auflagefläche kann gemäß einer alternativen Ausführungsform durch wabenförmige oder kreisförmige, konzentrisch zum Zentrum angeordnete Vertiefungen verkleinert werden. Die Tiefe der Vertiefung(en) 18 kann gemäß einer vorteilhaften Ausführungsform der Tiefe der Vakuumbahnen 4 entsprechen.

Der Nanostrukturstempel 5 sowie gegebenenfalls auch andere angrenzenden Bestandteile der Stempelhalterung sind bevorzugt aus UV-transparenten Materialien gebildet.

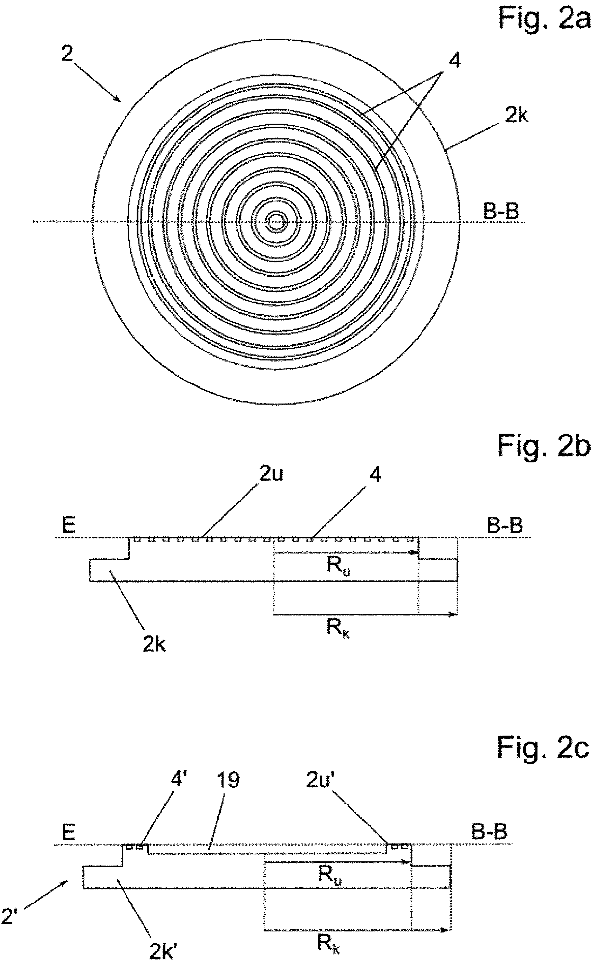

Figur 2a zeigt eine Substrataufnahmeeinrichtung 2 einer Vorrichtung zur Aufnahme des Substrats 7 auf einem Aufnahmekörper 2k. Der Aufnahmekörper 2k kann gemäß einer vorteilhaften Ausführungsform der Erfindung beschichtet sein. Der Aufnahmekörper 2k weist die parallel zur Aufnahmeebene E ausrichtbare Aufnahmefläche 2u auf (Figur 2b).

Die Aufnahmefläche 2u der Aufnahmeeinrichtung 2 ist bevorzugt an die Abmessungen des Substrats zumindest weitgehend angepasst. Die Aufnahmefläche 2u der Aufnahmeeinrichtung 2 ist in der Ausführungsform gemäß Figuren 2a und 2b kreisförmig und der Radius Rᵤ der Aufnahmefläche 2u entspricht zumindest weitgehend dem Radius der Substrate 7. Die Durchmesser der Substrate 7 entsprechen mit Vorzug den in der Halbleiterindustrie üblichen Durchmessern von 2", 4", 6", 8", 12" oder 18", mit Vorzug 18" oder größer.

Ein Radius Rₖ des Aufnahmekörpers 2k kann gemäß Figur 2b größer sein als der Radius Rᵤ der Aufnahmefläche 2u. In der Ausführungsform gemäß Figur 2b ist die gesamte Aufnahmefläche 2u zur Fixierung des Substrats 7 mittels Vakuumbahnen 4 vorgesehen. Im Ausführungsbeispiel gemäß Figur 2a wird der Unterdruck zur Fixierung des Substrats 7 an mehreren zueinander konzentrisch verlaufenden, die Aufnahmefläche 2u bedeckenden, Unterdruckkanälen bzw. Vakuumbahnen 4 durch eine Vakuumeinrichtung (nicht dargestellt) angelegt.

In Figur 2c wird die Aufnahmefläche 2u' gemäß einer zweiten Ausführungsform des Aufnahmekörpers 2k' nicht vollflächig ausgeführt, sondern eine gegenüber der Aufnahmefläche 2u' zurückgesetzte, insbesondere von der Aufnahmefläche 2u' umgebene, vorzugsweise umschlossene, Vertiefung 19 vorgesehen. Diese verändert die Auflagefläche des Substrats 7 so, dass insbesondere beidseitig strukturierte bzw. beidseitig prozessierte Substrate 7 eingesetzt werden können. Die Auflagefläche kann gemäß einer alternativen Ausführungsform durch wabenförmige oder kreisförmige, konzentrisch zum Zentrum angeordnete Vertiefung(en) 19 verkleinert werden. Die Tiefe der Vertiefung(en) 19 kann gemäß einer vorteilhaften Ausführungsform der Tiefe der Vakuumbahnen 4' entsprechen.

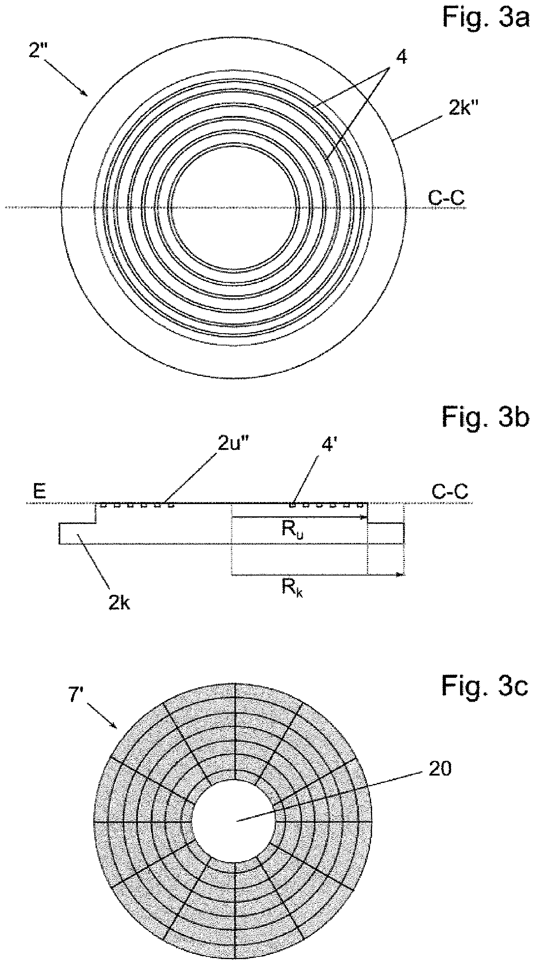

Figur 3a zeigt eine Substrataufnahmeeinrichtung 2" einer Vorrichtung zur Aufnahme eines ringförmigen Substrats 7' (siehe Figur 3c) auf einem Aufnahmekörper 2k" gemäß einer dritten Ausführungsform für ein Substrat 7' mit einem Loch 20 im Zentrum des Substrats 7'. Als Substrat 7' mit Loch 20 kommt beispielsweise eine Festplatte (Harddisk) in Frage. Eine Aufnahmefläche 2u" der Aufnahmeeinrichtung 2" ist an die Abmessungen des Substrats 7' angepasst. Die Aufnahmefläche 2u" der Aufnahmeeinrichtung 2" ist in der Ausführungsform gemäß Figuren 3a und 3b kreisförmig und ein Radius Rᵤ der Aufnahmefläche 2u" entspricht weitgehend dem Radius der Substrate 7'.

Gemäß Figur 3b ist nur ein etwa den halben Radius Rᵤ bedeckender, äußerer Ringabschnitt von der Aufnahmefläche 2u" zur Fixierung des Substrats 7' mittels Vakuumbahnen 4' vorgesehen. Das Substrat 7' wird somit durch Unterdruck an mehreren zueinander konzentrisch verlaufenden, der gesamten ringförmigen Substratfläche entsprechenden, Unterdruckkanälen bzw. Vakuumbahnen 4' durch eine Vakuumeinrichtung (nicht dargestellt) fixiert.

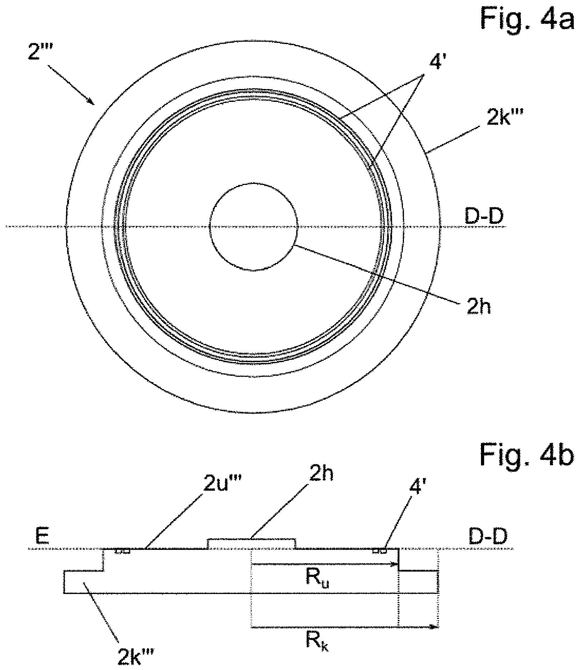

Figur 4a zeigt eine weitere Substrataufnahmeeinrichtung 2''' einer Vorrichtung zur Aufnahme des Substrats 7' auf einem Aufnahmekörper 2k''' gemäß einer vierten Ausführungsform für das Substrat 7' mit Loch 20 (Figur 3c).

Eine Aufnahmefläche 2u''' zur Fixierung des Substrats 7' enthält einen, insbesondere mit dem Loch 20 korrespondierenden, gegenüber der Aufnahmefläche 2u''' vorstehenden Kern 2h. Der Kern 2h der Substrataufnahmeeinrichtung 2''' für Substrate 7' kann verschiedene Formen aufweisen wie z.B. rund, kreuzförmig, sternförmig, oval oder eckig. Die Höhe des Kerns 2h entspricht insbesondere der Dicke der Substrate 7'. Die durchschnittliche Dicke der Substrate 7' liegt insbesondere zwischen 20 und 10000 µm, vorzugsweise zwischen 100 und 2000 µm, mit größerem Vorzug zwischen 250 und 1000 µm. Die Aufnahmefläche 2u''' und der Kern 2h können andere Maße aufweisen sodass auch andere Medien fixiert werden können.

Die Aufnahmefläche 2u''' der Aufnahmeeinrichtung 2''' ist in der Ausführungsform gemäß Figuren 4a und 4b kreisförmig und ein Radius Rᵤ der Aufnahmefläche 2u''' entspricht weitgehend dem Radius der Substrate 7'. In der Ausführungsform gemäß Figur 4b ist nur ein äußerer Ringabschnitt von der Aufnahmefläche 2u''' zur Fixierung des Substrats 7' mittels Vakuumbahnen 4' versehen. Das Substrat 7' mit Loch 20 wird somit im Ausführungsbeispiel gemäß Figur 4b durch Unterdruck an zwei zueinander konzentrisch verlaufenden, die Aufnahmefläche 2u am äußeren Ringabschnitt bedeckenden, Unterdruckkanälen bzw. Vakuumbahnen 4 durch eine Vakuumeinrichtung (nicht dargestellt) fixiert.

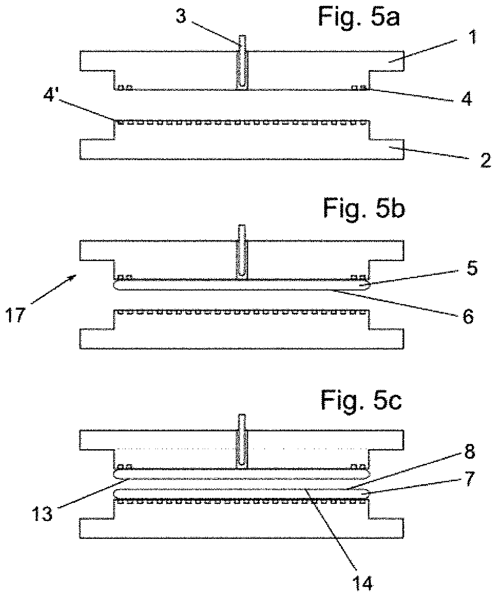

Figur 5a zeigt die Aufnahmeeinrichtungen 1 (Ausführungsform gemäß Figur 1a) und 2 (Ausführungsform gemäß Figur 2a) (in der Halbleiterindustrie auch als Chuck bezeichnet) einer Vorrichtung zur Aufnahme des Nanostrukturstempels 5 und des Substrats 7. Die Aufnahmeeinrichtung 1 enthält eine zentrische Öffnung 10 zur Durchführung eines Aktuators 3 (siehe auch Figur 1a) bzw. einer Aktuatoreinrichtung (nicht dargestellt).

In dieser ersten erfindungsgemäßen Ausführungsform wird der Prägeprozess (Nanoimprintprozess) mit dem Aktuator 3 im Substratzentrum initiiert. Der Aktuator 3 kann erfindungsgemäß verschiedene Formen bzw. Ausführungen haben. Anstatt einem Aktuator-Pin oder Stift als Aktuator 3 ist alternativ auch eine Druckbeaufschlagung mit einem Fluid oder einem Gas denkbar. Die Öffnung 10 für den Aktuator 3 gemäß Figur 1a kann verschiedene Größen und Formen haben.

Figur 5b zeigt die Vorrichtung mit auf die Stempelaufnahmeeinrichtung 1 geladenem, insbesondere UV-transparenten, Nanostrukturstempel 5. Die Fixierung des Nanostrukturstempels 5 erfolgt durch Vakuum bzw. Unterdruck über die Vakuumbahnen 4 im äußeren Ringabschnitt der Stempelaufnahmeeinrichtung 1.

Im nächsten Prozessschritt gemäß Figur 5c wird das Substrat 7 auf die Substrataufnahmeeinrichtung 2 geladen und durch Vakuum bzw. Unterdruck über die Vakuumbahnen 4' fixiert, wobei ein auf dem Substat 7 aufgebrachtes aushärtbares Material 8 mit einer Stempelfläche 14 nach oben, also in Richtung des Nanostrukturstempels 5 zeigt. Das Substrat 7 und der Nanostrukturstempel 5 werden während eines Evakuierungs- und/oder Inertgas-Spülvorgangs in Separation gehalten (also noch nicht kontaktiert), wobei der Nanostrukturstempel 5 oben mit der Prägeseite 6 nach unten und das Substrat 7 unten mit dem aushärtbaren Material 8 nach oben angeordnet und ausgerichtet werden.

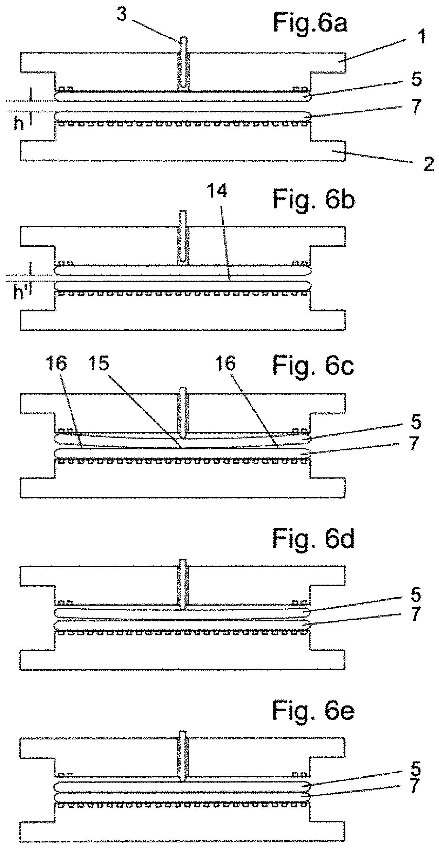

Figuren 6a bis 6e zeigen die Prozessschritte in einer ersten erfindungsgemäßen Ausführungsform der Vorrichtung und des Verfahrens für einen großflächigen Nanoimprintvorgang mit einem harten, UV-transparenten Nanostrukturstempel 5. Das Substrat 7 und der Nanostrukturstempel 5 werden zuerst hochgenau justiert für eine exakte Ausrichtung und während des Evakuierungs- und/oder Inertgas Spülvorgangs in Separation gehalten (Figur 6a).

Wie in Figur 6b gezeigt, wird ein Abstand h zwischen Substrat 7 und Nanostrukturstempel 5 auf einen genau definierten Abstand h' reduziert, bevor der Nanoimprintprozess gestartet wird. Dabei ist der Abstand h' insbesondere kleiner als 500 µm, mit Vorzug kleiner als 250 µm, mit größtem Vorzug kleiner als 100 µm, mit allergrößtem Vorzug kleiner als 50 µm.

Mittels des Aktuators 3 werden der Nanostrukturstempel 5 und das Substrat 7 möglichst punktförmig an einer Teilfläche 15 kontaktiert. Die in Figur 6c gezeigte Kontaktierung erfolgt durch eine konzentrische Verformung des Nanostrukturstempels 5 durch den über den Aktuator 3 ausgeübten Druck, insbesondere in der Mitte des Nanostrukturstempels 5. Dabei ist es vorteilhaft, eine resultierende Kraft Fₐ durch die Ansteuerung des Aktuators 3 bzw. der Aktuator-Einrichtung (nicht dargestellt) im Flächenschwerpunkt des Nanostrukturstempels 5 und somit im Flächenschwerpunkt einer Kontaktfläche zwischen dem Substrat 7 und dem Nanostrukturstempel 5 anzulegen.

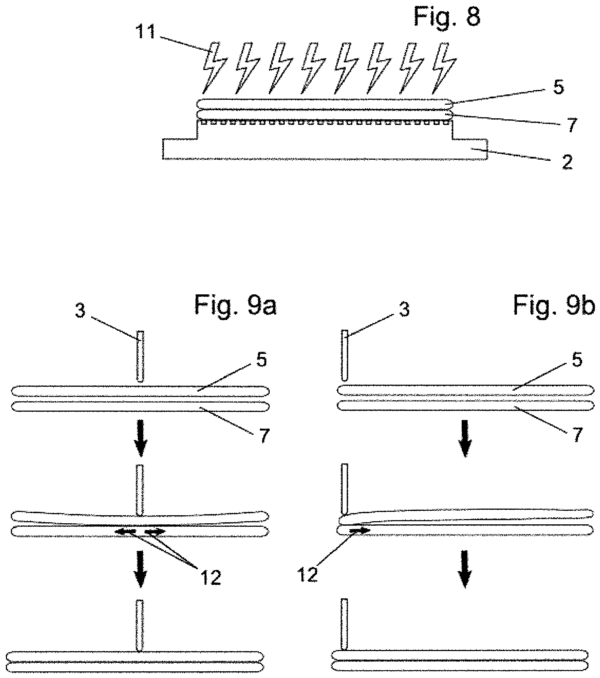

Nachdem der erste Kontaktpunkt erreicht wurde, wird durch gesteuerte Reduzierung des Unterdrucks ein Loslösen des Nanostrukturstempels 5 von der Stempelaufnahmeeinrichtung 1 bewirkt, wonach sich eine Prägefront 12 vom Zentrum, insbesondere konzentrisch, bis zum Rand des Substrats 7 beziehungsweise der Stempelfläche 14 hin ausbreitet. Durch die mittels der Verformung des Nanostrukturstempels 5 eingebrachte Vorspannung wird der Nanostrukturstempel 5 ausgehend von der Mitte des Nanostrukturstempels 5 radial nach außen bis zum Umfang mit dem Substrat 7 kontaktiert (siehe auch Figur 9a). Durch das Loslösen wird demnach eine Restfläche 16 der Stempelfläche 14 kontaktiert.

Figur 6e zeigt eine abgeschlossene Prägung, bei der die Prägefront 12 den Rand des Substrats 7 erreicht hat. Das Substrat 7 und der Nanostrukturstempel 5 sind annähernd vollflächig kontaktiert. Anschließend kann die Aushärtung gemäß Figur 8 erfolgen (siehe unten).

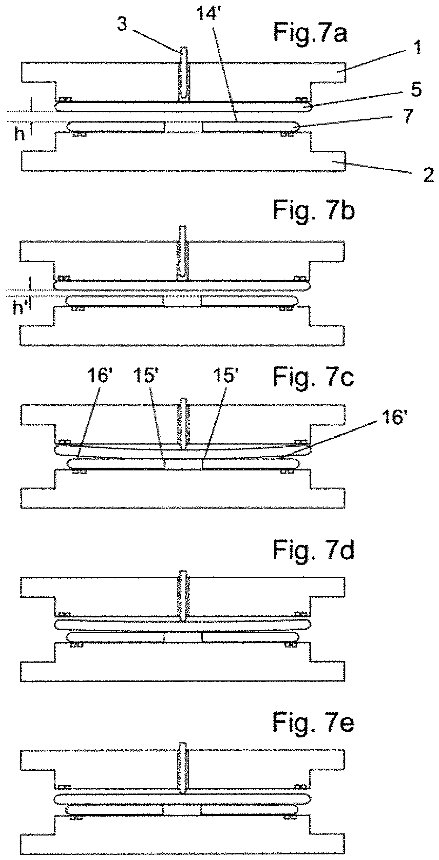

Figur 7a bis 7e zeigen die Prozessschritte in einer zweiten erfindungsgemäßen Ausführungsform der Vorrichtung und des Verfahrens für einen großflächigen Nanoimprint mit einem harten, UV-transparenten Nanostrukturstempel 5. Das Substrat 7 ist in diesem Ausführungsbeispiel das Substrat 7' gemäß Figur 3c.

Das Substrat 7' hat bevorzugt einen Durchmesser von 2,5 Zoll oder 3,5 Zoll. Der Stempel 7' hat einen Durchmesser von 4 Zoll oder größer und ist somit größer als das Substrat 7'. Die Aufnahmefläche 1u ist in einem äußeren Ringabschnitt des Aufnahmekörpers 1k zur Fixierung des Nanostrukturstempels 5 mittels Vakuumbahnen 4 ausgebildet (siehe Figur 1b). Somit liegen die Vakuumbahnen 4 der Aufnahmefläche 1u außerhalb von der aktiven Stempelfläche 14 des Nanostrukturstempels 5. Da das Substrat 7' mit Loch 20 einen kleineren Durchmesser als der Nanostrukturstempel 5 aufweist, liegen die Vakuumbahnen 4 für die Halterung des Nanostrukturstempels 5 außerhalb der zu prägenden Stempelfläche 14. Der Größenunterschied wird zur Fixierung des Nanostrukturstempels 5 mittels Vakuumbahnen 4 genutzt.

Wie in Figur 7b gezeigt, wird der Abstand h zwischen dem Substrat 7 und dem Nanostrukturstempel 5 auf einen genau definierten Abstand h' reduziert, bevor der Nanoimprintprozess gestartet wird. Dabei ist der Abstand h' insbesondere kleiner als 500 µm, mit Vorzug kleiner als 250 µm, mit größtem Vorzug kleiner als 100 µm, mit allergrößtem Vorzug kleiner als 50 µm.

Die, in Figur 7c gezeigte Kontaktierung erfolgt durch die konzentrische Verformung des Nanostrukturstempels 5 durch den über den Aktuator 3 ausgeübten Druck in der Mitte des Nanostrukturstempels 5. Dabei ist es vorteilhaft, die resultierende Kraft Fₐ durch die Ansteuerung des Aktuators 3 bzw. der Aktuator-Einrichtung (nicht dargestellt) im Flächenschwerpunkt des Nanostrukturstempels 5 und somit im Flächenschwerpunkt einer Kontaktfläche zwischen Substrat 7' und Nanostrukturstempel 5 anzulegen.

Die Kontaktfläche ist wegen des zentrischen Lochs 20 des Substrats 7' eine ringförmige Teilfläche 15' der Stempelfläche 14, wobei die Prägefront 12 am Rand des Loches 20 beginnt.

Nachdem die ringförmige Kontaktierung erfolgt ist, wird durch gesteuerte Reduzierung des Unterdrucks der Vakuumbahnen 4 ein Loslösen des Nanostrukturstempels 5 von der Stempelaufnahmeeinrichtung 1 bewirkt. Durch die mittels der Verformung des Nanostrukturstempels 5 eingebrachte Vorspannung wird der Nanostrukturstempel 5 ausgehend von der Mitte des Nanostrukturstempels 5 radial nach außen bis zum Umfang des Substrats 7' mit dem Substrat 7' kontaktiert (siehe auch Figur 9a). Durch das Loslösen wird demnach eine Restfläche 16' der Stempelfläche 14 kontaktiert.

Sobald der Nanostrukturstempel 5 den Rand des Loches 20 kontaktiert, breitet sich die Prägefront 12 konzentrisch zum Substrat-Außenrand hin aus. Figur 7e zeigt eine abgeschlossene Prägefront 12. Das Substrat 7' und der Nanostrukturstempel 5 sind, bis auf das Loch 20, also an der gesamten Stempelfläche 14 vollflächig kontaktiert.

Figur 8 zeigt den Waferstapel bzw. Substrat-Stempel-Stapel auf einer Entlade-Station und eine direkte Vernetzung des aushärtbaren Materials 8, insbesondere Photoresist oder Lack, mittels UV-Licht 11. Allgemeiner kann die Aushärtung durch elektromagnetische Strahlung, durch Wärme, durch Strom, durch magnetische Felder oder andere Verfahren durchgeführt werden. Bevorzugt erfolgt die Aushärtung durch den transparenten Nanostrukturstempel 5 hindurch. In einer weiteren Ausführungsform wird die Aushärtung noch in der Imprint-Stage durchgeführt. Hier erfolgt die Aushärtung durch die transparente Stempelaufnahmeeinrichtung 1, 1' und durch den transparenten Nanostrukturstempel 5 hindurch.

Eine Aushärtung und Entformung des Nanostrukturstempels 5 von dem Substrat 7, 7' kann direkt in der Imprint-Stage stattfinden. Bevorzugt verfügt die Anlage mit der erfindungsgemäßen Vorrichtung über eine Modulgruppe mit einem gemeinsamen, und bei Bedarf gegenüber der Umgebungsatmosphäre abschließbaren Arbeitsraum. Dabei können die Module, z.B. Belackungs-Modul, Imprint-Modul und Entlade-Modul, clusterförmig oder sternförmig um ein Zentralmodul mit einer Bewegungseinrichtung (Robotersystem) angeordnet werden.

Das Verfahren ermöglicht eine hochauflösende Strukturierung im sub-µm Bereich, mit Vorzug unter 100 nm, mit größerem Vorzug unter 50 nm, mit allergrößtem Vorzug unter 10 nm.

Eine alternative Ausführungsform ist in Figur 9b gezeigt. Hier wird der Nanoimprintprozess mit einem Aktuator 3 außermittig, insbesondere am Substratrand, initiiert und die Prägefront 12 breitet sich vom Kontaktpunkt kreisförmig aus.

Die Ausbreitungsrichtung(en) der Prägefronten 12 gemäß den ersten und zweiten Ausführungsformen werden in den Figuren 9a und 9b schematisch gegenübergestellt. Beispiele für die Position des Aktuators 3 sind in den Figuren 9a und 9b gezeigt.

### Bezugszeichenliste

- 1, 1': Stempelaufnahmeeinrichtung
- 1k, 1k': Aufnahmekörper
- 1u, 1u': Aufnahmefläche
- 2, 2', 2", 2''': Substrataufnahmeeinrichtung
- 2u, 2u', 2u", 2u''': Aufnahmefläche
- 2k, 2k', 2k", 2k''': Aufnahmekörper
- 2h: Kern
- 3: Aktuator (Pin)
- 4: Vakuumbahnen
- 4': Vakuumbahnen
- 5: Nanostrukturstempel
- 5a: Aufnahmeseite
- 6: Prägeseite
- 7, 7': Substrat
- 8: aushärtbares Material
- 9: Ringabschnitt
- 10: Öffnung
- 11: UV-Licht
- 12: Präge-Front Richtung
- 13: Nanostruktur
- 14, 14': Stempelfläche
- 15, 15': Teilfläche
- 16, 16': Restfläche
- 17: Prägeeinrichtung (insbesondere bestehend aus Stempelaufnahmeeinrichtung und Nanostrukturstempel)
- 18: Vertiefung
- 19: Vertiefung
- 20: Loch
- A-A, B-B, C-C, D-D: Schnittlinie
- E: Aufnahmeebene
- Rᵤ: Ringradius
- Rₖ: Radius des Aufnahmekörpers
- Fₐ: Kraft

## Patentansprüche

1. Verfahren zum Prägen einer Nanostruktur (13) von einem Nanostrukturstempel (5) in eine Stempelfläche (14) eines auf ein Substrat (7) aufgebrachten, aushärtbaren Materials (8) mit folgenden Schritten, insbesondere folgendem Ablauf:
- Ausrichten der Nanostruktur (13) gegenüber der Stempelfläche (14),
- Prägen der Stempelfläche (14) durch
A) Vorspannung des Nanostrukturstempels (5) durch Verformung des Nanostrukturstempels (5),
B) Kontaktieren einer Teilfläche (15) der Stempelfläche (14) mit dem Nanostrukturstempel (5) und
C) Loslassen des Nanostrukturstempels (5) und dadurch selbsttätiges Kontaktieren der Restfläche (16) zumindest teilweise, insbesondere überwiegend, durch die Vorspannung des Nanostrukturstempels (5).

2. Verfahren nach Anspruch 1, bei dem der Nanostrukturstempel (5) zumindest überwiegend aus mindestens einem der folgenden, harten, insbesondere UV-transparenten, Materialien gebildet ist:
- Quarz und/oder
- Siliziumdioxid und/oder
- Polymere, insbesondere Polydimethylsiloxan, Polytetrafluorethylen, perfluorierte Polyether, Polyvinylalkohol, Polyvinylchlorid und/oder Ethylentetrafluorethylen.

3. Verfahren nach einem der vorhergehenden Ansprüche, bei dem eine optische Transparenz des Nanostrukturstempels (5) größer als 0%, mit Vorzug größer als 20%, mit größerem Vorzug größer als 50%, mit größtem Vorzug größer als 80%, mit allergrößtem Vorzug größer als 95% ist.

4. Verfahren nach einem der vorhergehenden Ansprüche, bei dem der Nanostrukturstempel (5) mittels einer Stempelaufnahmeeinrichtung (1) gehalten, bewegt und gegebenenfalls verformt wird.

5. Verfahren nach einem der vorhergehenden Ansprüche, bei dem das Substrat (7) mittels einer Substrataufnahmeeinrichtung (2) gehalten, bewegt und gegebenenfalls verformt wird.

6. Verfahren nach einem der vorhergehenden Ansprüche, bei dem die Stempelaufnahmeeinrichtung (1) einen Aktuator (3) zur Verformung des Nanostrukturstempels (5) aufweist.

7. Verfahren nach einem der vorhergehenden Ansprüche, bei dem das Material (8) nach dem vollständigen Kontaktieren, insbesondere mittels Licht, vorzugsweise durch den Nanostrukturstempel (5) hindurch, ausgehärtet wird.

8. Vorrichtung zum Prägen einer Nanostruktur (13) von einem Nanostrukturstempel (5) in eine Stempelfläche (14) eines auf ein Substrat (7) aufgebrachten, aushärtbaren Materials (8) mit:
- Ausrichtmitteln zum Ausrichten der Nanostruktur (13) gegenüber der Stempelfläche (14),
- einer Prägeeinrichtung (17) zum Prägen der Stempelfläche (14) durch
A) erste Vorspannmittel (3, 4) zur Vorspannung des Nanostrukturstempels (5) durch Verformung des Nanostrukturstempels (5),
B) Kontaktiermittel zum Kontaktieren einer Teilfläche (15) der Stempelfläche (14) mit dem Nanostrukturstempel (5) und
C) Mittel zum selbsttätigen Kontaktieren der Restfläche (16) durch Loslassen des Nanostrukturstempels (5) und zumindest teilweise, insbesondere überwiegend, durch die Vorspannung des Nanostrukturstempels (5).

## Claims

1. A method for embossing of a nanostructure (13) from a nanostructure punch (5) into a punch surface (14) of a curable material (8) which has been applied to a substrate (7) with the following steps, especially following sequence:
- Alignment of the nanostructure (13) relative to the punch surface (14),
- Embossing of the punch surface (14) by
A) Prestressing of the nanostructure punch (5) by deformation of the nanostructure punch (5),
B) Making contact of a partial area (15) of the punch surface (14) with the nanostructure punch (5) and
C) Releasing the nanostructure punch (5) and as a result automatic contacting of the remaining surface (16) at least partially, especially predominantly, by the prestressing of the nanostructure punch (5).

2. The method as claimed in Claim 1, wherein the nanostructure punch (5) is formed at least predominantly from at least one of the following, hard, in particular UV-transparent materials:
- quartz and/or
- silicon dioxide and/or
- polymers, in particular polydimethylsiloxane, polytetrafluorethylene, perfluorinated polyether, polyvinyl alcohol, polyvinyl chloride, and/or ethylene tetrafluorethylene.

3. The method as claimed in one of the preceding claims, wherein an optical transparency of the nanostructure punch (5) is greater than 0%, preferably greater than 20%, more preferably greater than 50%, most preferably greater than 80%, most preferably of all greater than 95%.

4. The method as claimed in one of the preceding claims, wherein the nanostructure punch (5) is held, moved and optionally deformed by means of a punch chucking apparatus (1).

5. The method as claimed in one of the preceding claims, wherein the substrate (7) is held, moved and optionally deformed by means of a substrate chucking apparatus (2).

6. The method as claimed in one of the preceding claims, wherein the punch chucking apparatus (1) has an actuator (3) for deformation of the nanostructure punch (5).

7. The method as claimed in one of the preceding claims, wherein the material (8) is cured after complete contact has been made, especially by means of light, preferably through the nanostructure punch (5).

8. A device for embossing of a nanostructure (13) from a nanostructure punch (5) into a punch surface (14) of a curable material (8) which has been applied to a substrate (7) with the following:
- alignment means for aligning the nanostructure (13) relative to the punch surface (14),
- an embossing apparatus (17) for embossing of the punch surface (14) by
A) first prestressing means (3, 4) for prestressing of the nanostructure punch (5) by deformation of the nanostructure punch (5),
B) Contact-making means for making contact of a partial area (15) of the punch surface (14) with the nanostructure punch (5) and
C) Means for automatic contacting of the remaining surface (16) by releasing the nanostructure punch (5) and at least partially, especially predominantly, by the prestressing of the nanostructure punch (5).

## Revendications

1. Procédé pour le marquage d'une nanostructure (13) d'un poinçon de nanostructure (5) dans une surface à poinçon (14) d'un matériau (8) pouvant être durci appliqué sur un substrat (7), comprenant les étapes suivantes, en particulier le déroulement suivant :
- alignement de la nanostructure (13) par rapport à la surface de poinçon (14),
- marquage de la surface à poinçon (14) par
A) pré-tension du poinçon de nanostructure (5) par déformation du poinçon de nanostructure (5),
B) mise en contact d'une surface partielle (15) de la surface à poinçon (14) avec le poinçon de nanostructure (5) et
C) lâchage du poinçon de nanostructure (5) et ainsi mise en contact automatique de la surface restante (16) au moins partiellement, en partie en majorité, par la pré-tension du poinçon de nanostructure (5).

2. Procédé selon la revendication 1, dans lequel le poinçon de nanostructure (5) est formé au moins en majorité à partir d'au moins un des matériaux durs, en particulier transparents aux UV suivants :
- Quartz et/ou
- dioxyde de silicium et/ou
- polymères, en particulier polydiméthylsiloxane, polytétratfluoréthylène, polyéther perfluoré, alcool polyvinylique, chlorure de polyvinyle et/ou éthylène tétrafluoroéthylène.

3. Procédé selon l'une des revendications précédentes, dans lequel une transparence optique du poinçon de nanostructure (5) est supérieure à 0 %, de préférence supérieure à 20 %, plus encore de préférence supérieure à 50 %, avec la plus grande préférence supérieure à 80 % et de manière préférée entre toutes supérieure à 95 %.

4. Procédé selon l'une des revendications précédentes, dans lequel le poinçon de nanostructure (5) est maintenu, déplacé et le cas échéant déformé au moyen d'un dispositif de réception de poinçon (1).

5. Procédé selon l'une des revendications précédentes, dans lequel le substrat (7) est maintenu, déplacé et le cas échéant déformé au moyen d'un dispositif de réception de substrat (2).

6. Procédé selon l'une des revendications précédentes, dans lequel le dispositif de réception de poinçon (1) présente un déclencheur (3) pour déformer le poinçon de nanostructure (5).

7. Procédé selon l'une des revendications précédentes, dans lequel le matériau (8), après la mise en contact complète, en particulier au moyen de lumière, est durci, de préférence au travers du poinçon de nanostructure (5).

8. Dispositif pour le marquage d'une nanostructure (13) d'un poinçon de nanostructure (5) dans une surface à poinçon (14) d'un matériau (8) pouvant être durci appliqué sur un substrat (7), comprenant :
- des moyens d'alignement pour aligner la nanostructure (13) par rapport à la surface de poinçon (14),
- un dispositif de marquage (17) pour marquer la surface à poinçon (14) par
A) des premiers moyens de pré-tension (3, 4) pour la pré-tension du
poinçon de nanostructure (5) par déformation du poinçon de nanostructure (5),
B) des moyens de mise en contact pour la mise en contact d'une surface partielle (15) de la surface à poinçon (14) avec le poinçon de nanostructure (5) et
C) des moyens pour la mise en contact automatique de la surface restante (16) par lâchage du poinçon de nanostructure (5) et au moins partiellement, en partie en majorité, par la pré-tension du poinçon de nanostructure (5).
